# EUROPEAN PATENT APPLICATION

(11) **EP 3 093 848 A1**
(43) Date of publication of application: **16.11.2016**
(21) Application number: 15305717.9
(22) Date of filing: 13.05.2015
(51) Int. Cl.: G11B 20/02, G11B 20/22, G11B 20/24, G10L 21/0208, H03G 3/34

(54) **ATTENUATING METHOD AND CORRESPONDING DEVICE**

(71) Applicant: Thomson Licensing, 92130 Issy-les-Moulineaux (FR)
(72) Inventor: Gallou, Gilles, 35576 CESSON SEVIGNE CEDEX (FR); Morillon, Gilles, 35576 CESSON SEVIGNE CEDEX (FR); Poupard, Frederic, 35576 CESSON SEVIGNE CEDEX (FR)
(74) Representative: Perrot, Sébastien

(57) **Abstract**

The present disclosure relates to a method, to be performed in a signal processing device, for attenuating a peak present in a first analog signal.

According to an embodiment, the method comprises:
- delaying said first analog signal for a first given duration;
- obtaining in said first given duration a corrective analog signal, said corrective analog signal being temporally aligned with said delayed first analog signal, said obtaining comprising:
• converting said first analog signal to a first digital signal;
• generating a second digital signal from said first digital signal by isolating said a peak;
• building said corrective analog signal from said second digital signal thanks to an audio to digital conversion;

- merging said delayed analog signal with said corrective analog signal.

## Description

### 1. Technical field

The present disclosure relates to the field of signal processing, for instance audio processing.

An attenuating method and corresponding device are described.

### 2. Background art

After having being replaced for a while by digital disks (CD), vinyl records are becoming again popular. Indeed, for music experts, the analog sound originating from an analog record is better than the sound originating from a digital disc.

However, when listening to an analog record, some clicks and/or plops can happen, which are unpleasant for the listener.

Some prior art technics have tried to bring a solution to get rid of the clicks and/or plops by converting the analog sound to digital sound and then filtering the digital sound by removing the clicks and plops, then converting filtered digital sound to analog sound.

However, for music experts, such a solution has the disadvantage of deteriorating the quality of the analog sound. Because of the sampling of the signal, inherent to a conversion from an analog signal to a digital signal, such analog to digital conversion can often suppress harmonics or other subtle variations that were initially present in the analog signal.

So, there's a need to provide a solution that improve the user experience during the rendering of an analog record compared to prior art solutions.

### 3. Summary of the present disclosure.

The present principles enable at least one of the above disadvantages to be resolved by proposing a method, to be performed in a signal processing device, for attenuating a peak present in a first analog signal.

According to an embodiment of the present disclosure, said method comprises:
- delaying said first analog signal for a first given duration;
- obtaining in said first given duration a corrective analog signal, said corrective analog signal being temporally aligned with said delayed first analog signal, said obtaining comprising:
   - converting said first analog signal to a first digital signal;
   - generating a second digital signal from said first digital signal by isolating at least a peak;
   - building said corrective analog signal from said second digital signal thanks to an audio to digital conversion;
- merging said delayed analog signal with said corrective analog signal.

According to an embodiment of the present disclosure, said obtaining is performed simultaneously to said delaying.

According to an embodiment of the present disclosure, said building comprises:
- inverting the polarity of said second digital signal;
- audio to digital converting of said inverted second digital signal; and
said merging comprises adding said delayed analog audio signal with said corrective analog signal.

According to an embodiment of the present disclosure, said building comprises:
- converting said second digital signal to a second analog signal;
- inverting the polarity of said second analog signal; and
said merging comprises adding said delayed analog audio signal with said corrective analog signal.

According to an embodiment of the present disclosure, said corrective signal has the same polarity than the first analog signal and said merging comprises subtracting said corrective analog signal from said delayed analog audio signal.

According to an embodiment of the present disclosure, said attenuating method comprises tuning said first given duration.

According to an embodiment of the present disclosure, said signal processing device is configurable in a tuning mode and said tuning is performed when said signal processing device is in said tuning mode.

According to an embodiment of the present disclosure, said tuning comprises :
- obtaining a third analog signal, said obtaining comprising:
   - converting said first analog signal to a third digital signal;
   - delaying said third digital signal for a second given duration;
   - building said third analog signal from said third digital signal thanks to an audio to digital conversion;
- merging said delayed analog signal with said third analog signal;
- modifying said given duration according to the power of the merged signals.

According to an embodiment of the present disclosure, during said tuning, said obtaining of a third analog signal is performed simultaneously to said delaying.

According to another aspect, the present disclosure relates to a signal processing device for attenuating a peak present in a first analog signal.

According to an embodiment of the present disclosure, said signal processing device comprises:
- a delay module, configured for delaying said first analog signal for a first given duration;
- an obtaining module, configured for obtaining a corrective analog signal in said first given duration, said corrective analog signal being temporally aligned with said delayed first analog signal, said obtaining module comprising:
   - an audio to digital converter, configured for converting said first analog signal to a first digital signal;
   - a generating module, configured for generating a second digital signal from said first digital signal by isolating at least a peak;
   - a Building module, configured for building said corrective analog signal from said second digital signal thanks to an audio to digital conversion;
- a merging module, configured for merging said delayed analog signal with said corrective analog signal.

According to an embodiment of the present disclosure, said isolating module comprises a high pass filtering module.

According to an embodiment of the present disclosure, said isolating module comprises a smooth filtering module.

According to an embodiment of the present disclosure, said signal processing device comprises an acquiring module for acquiring said first analog signal from an analog sound record.

According to an embodiment of the present disclosure, said signal processing device comprises at least a tuning module configured for adjusting said first given duration.

According to an embodiment of the present disclosure, said tuning module comprises a delay setting module.

According to an embodiment of the present disclosure, said tuning module comprises at least two delay setting modules.

According to an embodiment of the present disclosure, said tuning module comprises a power level processing unit.

While not explicitly described, the signal processing device of the present disclosure can be adapted to perform the attenuating method of the present disclosure in any of its embodiments.

While not explicitly described, most of the present embodiments related to an attenuating method or to the corresponding signal processing device can be employed in any combination or sub-combination. For example, some embodiments may involve a corrective signal having the same polarity than the first analog signal and a merging comprising subtracting said corrective analog signal from said delayed analog audio signal and a tuning of said first given duration.

As will be appreciated by one skilled in the art, some aspects of the present disclosure can be embodied as a system, method, or computer readable medium. Accordingly, aspects of the present disclosure can take the form of an entirely hardware embodiment, a software embodiment (including firmware, resident software, micro-code, and so forth), or an embodiment combining software and hardware aspects that can all generally be referred to herein as a "circuit", module" or "system". Furthermore, some aspects of the present disclosure can take the form of a computer readable storage medium. Any combination of one or more computer readable storage medium(s) may be utilized.

A computer readable storage medium can take the form of a computer readable program product embodied in one or more computer readable medium(s) and having computer readable program code embodied thereon that is executable by a computer. A computer readable storage medium as used herein is considered a non-transitory storage medium given the inherent capability to store the information therein as well as the inherent capability to provide retrieval of the information therefrom. A computer readable storage medium can be, for example, but is not limited to, an electronic, magnetic, optical, electromagnetic, infrared, or semiconductor system, apparatus, or device, or any suitable combination of the foregoing.

It is to be appreciated that the following, while providing more specific examples of computer readable storage mediums to which the present disclosure can be applied, is merely an illustrative and not exhaustive listing as is readily appreciated by one of ordinary skill in the art: a portable computer diskette: a hard disk, a read-only memory (ROM), an erasable programmable read-only memory (EPROM or Flash memory), a portable compact disc read-only memory (CD-ROM), an optical storage device; a magnetic storage device, or any suitable combination of the foregoing.

Thus, for example, it will be appreciated by those skilled in the art that the block diagrams presented herein represent conceptual views of illustrative system components and/or circuitry of some embodiments of the present disclosure. Similarly, it will be appreciated that any flow charts, flow diagrams, state transition diagrams, pseudo code, and the like represent various processes which may be substantially represented in computer readable storage media and so executed by a computer or processor, whether or not such computer or processor is explicitly shown.

### 4. Description of drawings.

The present disclosure will be better understood, and other specific features and advantages will emerge upon reading the following description, the description making reference to the annexed drawings wherein:
- Figure 1 illustrates a structure of a signal processing device according to a particular embodiment of the present disclosure;
- Figure 2 is a fonctionnal diagram that illustrates a particular embodiment of the attenuating method of the present disclosure, compatible with the embodiment illustrated by figure 1;
- Figure 3 illustrates a structure of a signal processing device according to another particular embodiment of the present disclosure, compatible with the embodiment illustrated in figure 1.
- Figure 4 illustrates a structure of a processing module of a signal processing device according to a particular embodiment of the present disclosure, compatible with the embodiments illustrated in figures 1 and 3.

It is to be noted that the drawings have only an illustration purpose and that the embodiments of the present disclosure are not limited to the illustrated embodiments.

### 5. Detailed description of the embodiments.

At least one embodiment of the present disclosure offers a new way of attenuating an analog signal, notably an analog sound signal acquired from a vinyl record, by attenuating undesirable peaks present in the signal, like peaks representative of click and/or plops in a sound signal, while preserving the analog nature of the signal, and notably the complexity and richness of a sound analog signal.

The principles of the disclosure consists of taking advantage of the facility of digital processing for isolating undesirable peaks like clicks and/or plops (which audio quality are not to be preserved) and then producing an analog corrective signal temporally aligned (or almost temporally aligned) with the original analog signal and comprising peaks that will compensate, or at least attenuate, at least an undesirable peak present in the original analog signal when merged with the original analog signal.

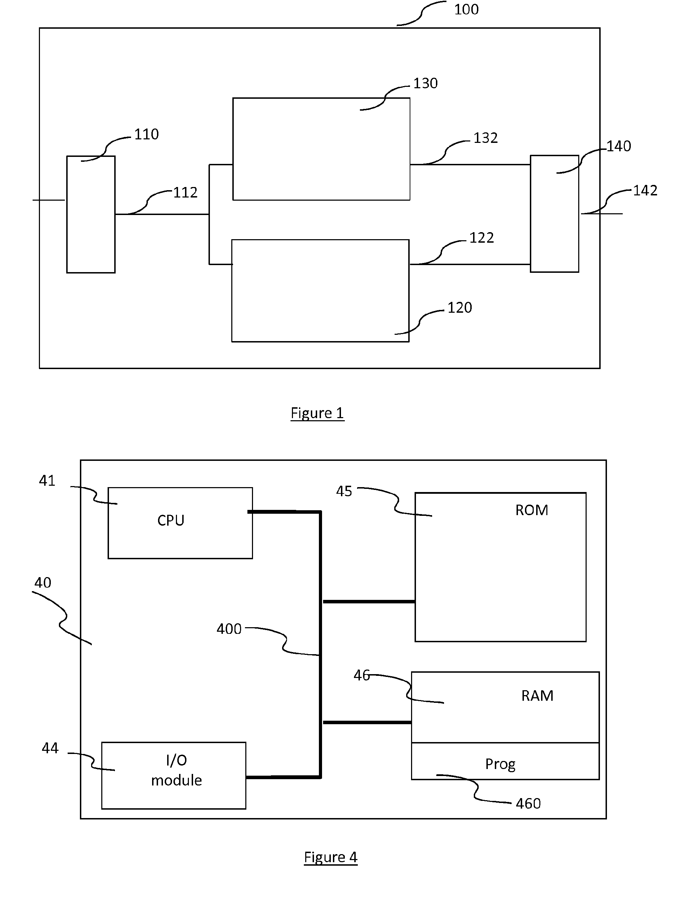

In the particular embodiment of figure 1, the method of the present disclosure is performed in an audio processing device, for instance a record player 100, which renders the content of vinyl records.

The record player comprises an acquiring module 110, comprising notably a reader head. The acquiring module may also comprise processing elements like a follower amplifier.

According to the present disclosure, the analog signal 112 output by the acquiring module 110 is processed in parallel in two different paths.

In a first path, the analog signal 112 is processed by an obtaining module 120 in order to obtain a corrective analog signal 122. In the illustrated embodiment, the corrective analog signal 122 comprises at least a peak adapted to compensate an undesirable peak present in the analog sound signal 112. For instance, a peak of the corrective analog signal can be a peak (called "corrective peak") with similar amplitude, eventually with an inverted polarity, compared to a given peak of the analog sound signal 112.

In a second path, the analog signal 112 is delayed, by a delay module 130, during the time necessary for the processing to be performed on the first path.

As a consequence, a given peak (representative of some clicks and plops) of the delayed audio signal 132 is temporally aligned with its corrective peak in the corrective analog signal 122.

The record player also comprises a merging module 140, which received as input the analog signal and the corrective analog signal and output a merged signal 142 in which at least a resulting peak is attenuated compared to the peaks of the acquired analog signal. Depending upon embodiments, the merge can consist of a subtraction or an addition.

In the some embodiment, where a corrective peak of a given peak of the analog signal has an inverted (or opposite) polarity, compared to the given peak, the merged signal can be an addition of both input signals. In other embodiments, where a corrective peak of a given peak of the analog signal has the same polarity than the acquired analog signal, the merged signal can be a subtraction of both input signals.

According to the particular embodiment described, the delay that will be applied to an acquired analog sound can be configured. For instance, it can be configured by the choice of the components of the delay module. It can also be set in factory by configuration of the delay module, for instance by assigning a value of a timer comprised in the delay module. This value can take into account a theoretical or empirical processing time of the obtaining module.

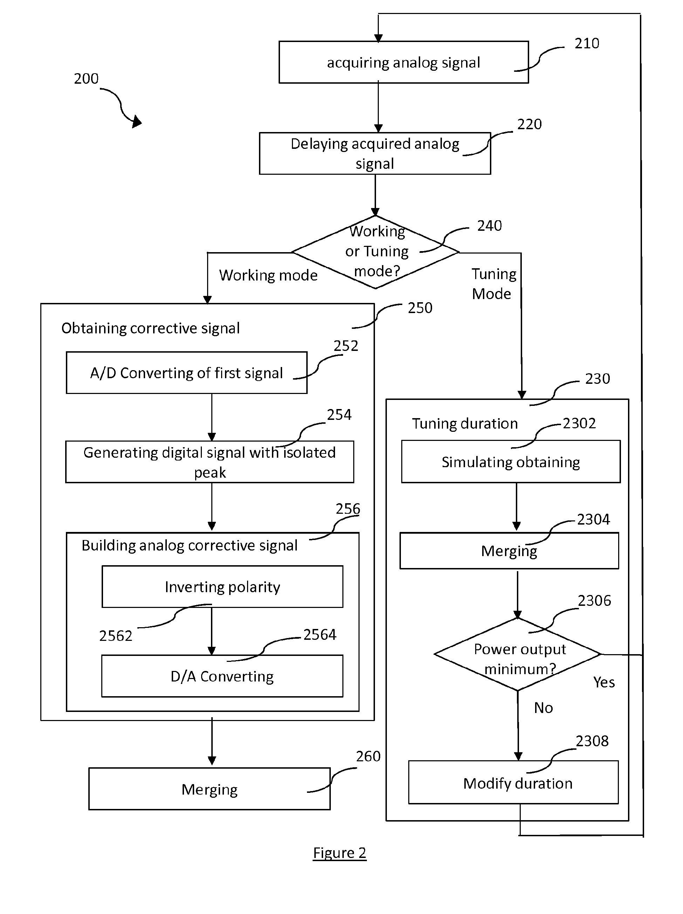

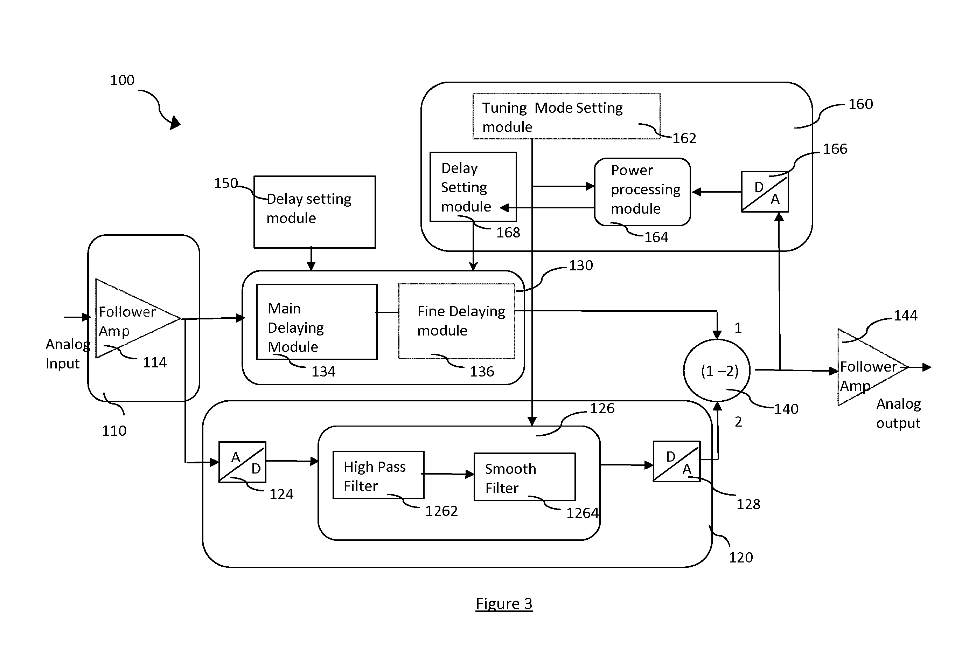

In some embodiment, eventually complementary with the above embodiment, the delay can be tuned dynamically thanks to a tuning module. Indeed, in some embodiments, the processing time of the obtaining can vary according to different factors, like the temperature of the components used to perform the obtaining, or the aging of the components. So, in some cases, it can be better to fine tune the duration of the delaying from times to times. Such a tuning module will be described more precisely in link with figures 2 and 3.

Figure 2 is a fonctionnal diagram that illustrates a particular embodiment of the attenuating method 200 of the present disclosure, compatible with the embodiment illustrated by figure 1.

In the described embodiment, the method 200 comprises an acquiring 210 of a first analog signal and a delaying 220 of the acquired signal.

In some embodiments, the duration of the delaying can be adjusted. For instance it can be adjusted manually thanks to a tuning button activated by a user when listening several times to a given record. In other embodiments, eventually complementary, it can be performed automatically.

Depending upon embodiments, the signal processing device can be set, mechanically (for instance thanks to a button) or electronically (for instance thanks to a smart card with an NFC tag and/or by an entering of a password) in a tuning mode, where the duration of delaying is adjusted, and/or in a working mode, where the acquired signal is improved.

In the tuning mode, the duration of delaying can be adjusted either manually or automatically.

The delaying 220 of the acquired analog signal permits to "wait" until an obtaining 250 of a corrective signal is performed.

In the illustrated embodiment, when the record player is in a working mode 240, the obtaining 250 is performed at the same time as the delaying and comprises an audio to digital converting 252 of the acquired analog signal, leading to a first digital signal. The obtaining 250 also comprises a generating 254 of a second digital signal, only (or mainly) comprising undesirable peaks present in the first digital signal.

Such generating 254 can comprise for example isolating parasite peaks from the first digital signal, and generating a second digital signal associated to the isolated parasite peaks.

Indeed, when the acquired analog signal is a sound signal, a peak representative of click and/or plops will often have a much higher amplitude that the signal part representative of the music.

Thus isolating can for instance be performed thanks to a high pass filter, having a threshold adapted to suppress the part of the digital signal representative of useful sound or voice and to keep the part of the digital signal representative of clicks and/or plops.

In some embodiments, the obtaining 250 can also comprises smooth filtering of the signal resulting from the isolating (thanks for instance to a "Hamming window" module). This smooth filtering is optional.

According to the illustrated embodiment, the obtaining 250 also comprises building 256 a corrective analog signal from the second digital signal. This building notably comprises an audio to digital converting 2564.

The method then comprises merging 260 of the obtained corrective analog signal and the delayed acquired analog signal. The time alignment of the peak of both merged signals permits to output a resulting signal ("corrected signal") with some undesirable peaks, like peaks representative of clicks and/or plops, being attenuated, and with the analog sound part of the resulting similar to the analog sound part of the input signal.

In some embodiment, the merging is a subtraction of both signals.

In others embodiments, like in figure 2, where the merging 260 is an addition of both signals, the building may also comprises an inverting 2562. Depending upon embodiments, the second digital signal may be inverted before its digital to audio converting (as illustrated by figure 2), or an inverting may be applied to the analog signal resulting from a digital to audio converting of the second digital signal.

As explained above, the method can comprise a tuning of the duration of the delaying of the acquired signal. Depending upon embodiments, the tuning can be performed on the signal to be attenuated, in parallel to the attenuation, and/or when the device in a tuning mode, and/or on a reference signal.

In the embodiment of figure 2, when the record player is in a tuning mode 240, the method comprises a manual or automatic tuning 230 of the duration of delaying. In the embodiment of figure 2, the tuning 230 comprises, after the delaying 240 of the acquired signal, a simulating 2302 of an obtaining of a corrective signal. This obtaining is similar to the obtaining performed when the signal processing device is in he working mode, except that some processing, notably some analog processing, is not performed.

More precisely, in the illustrated embodiment, during the simulating 2302, some processing (like audio to digital conversion, digital to audio conversion or inverting polarity) that can take a variable duration and does not result, in a cumulative perspective, in a significant alteration of the signal can effectively be performed, while some processings (like isolating peaks), that would otherwise alter significantly the signal and have a predictable duration, are not performed. Those processings are replaced by an extra delaying of the signal during the simulating 2302.

The tuning 230 then comprises merging 2304 the signal obtained by the simulating 2302 and the delayed acquired signal.

In some embodiments where the obtained signal has the same polarity than the acquired analog signal and where the merging is a subtraction, the signal resulting from the simulating is similar to the acquired signal. As a consequence, the signal that results from the merging 2304 will be almost null when both signals are temporally aligned.

Similarly, in embodiments where the obtaining (and the simulating of the obtaining) comprises polarity inverting and where the merging is an addition, the signal resulting from the simulating is an inversion of the acquired signal. As a consequence, the signal resulting for the merging will also be almost null when both signal are temporally aligned.

Thus, the tuning 230 is made according to the power value of the resulting signal. Notably, it comprises a modifying 2308 of the given duration of delaying, that is performed conditionally depending on the power value of the signal resulting from the merge. In some embodiments, the modifying 2308 can be performed manually by a user, until no rendered sound is audible. In other embodiment, eventually complementary, the modifying can be performed automatically. For instance, like in the illustrated embodiment of figure 2, the method 200 comprises a modifying 2308 of the duration when the power value (or the Root Means Square of the power value) of the resulting signal is minimum 2306 (that is to say for instance inferior or equal to a stored power value of a signal resulting from a former tuning). In other embodiments, the modifying 2308 can be performed according to a comparison between a given threshold and:
- the power value of the resulting signal, or
- a ratio between the power value of the acquired signal and the power value of the resulting signal,
- a ratio between the Root Means Square (RMS) power value of the acquired signal and the Root Means Square power value of the resulting signal.

The tuning has been described in link with the tuning mode of the device, as illustrated in figure 2.

However, in other embodiments, eventually complementary, the tuning can be performed without the need for the device to be in a tuning mode. In such an embodiment, an obtaining 250 and a merging 260 are performed in parallel with the tuning 230 on an acquired delayed signal.

Figure 3 now describes an example of a structure of a signal processing device 100 of the present disclosure being configurable in a tuning mode.

In the particular embodiment of figure 3, the signal processing device 100 is an audio processing device, for instance a vinyl record player. In other embodiments, it can be an audio tape player or another kind of audio processing device, for instance an audio improving device, with no audio rendering capability device, like a device adapted for duplicating a vinyl record master.

In other embodiments, it can also be a VHS player or an analog signal processing device (to be used in environments where cost and/or size constraints are important for instance).

The audio processing device 100 of figure 3 comprises notably:
- an acquiring module 110, comprising a follower amplifier 114, which receives an analog input signal;
- an obtaining module 120, comprising:
   o an audio to digital converter 124;
   o a click and plop extractor 126;
   o a digital to audio converter 128;
- a delaying module 130;
- a subtractor 140;
- a main delay setting module 150;
- a tuning module 160 (for an automatic tuning of the duration).

The given duration used by the delaying module can be a default duration chosen at the factory, according to the components of the device. Such default duration can be defined via the main delay setting module 150. It can be assigned for instance a value of less than 80 ms, like a value of 10, 27, 28, 50 or 60 ms.

The given duration can also be the result of a former tuning.

The main delay setting module 150 can also be used in order to manually modifying the duration after the delivering of the device (being or not configurable in a tuning mode).

The click and/or plop extractor 126 can be, for instance, a digital signal processor (DSP) 126 comprising a high pass filter 1262. It can also comprise a smooth filter 1264 (like a module called "hamming window module"). This filter is optional.

In the illustrated embodiment, the DSP 126 can be configured in a working mode (where it extracts peaks from an incoming digital signal) or in a tuning mode, where the extracting is replaced by a delaying, equal to the time of processing of the DSP in the working mode (for instance a delaying of less than 80 ms, like a delaying of 10, 27, 28, 50 or 60 ms).

In the embodiment of figure 3, the DSP 126 can be configured in tuning or working mode by the tuning module 160.

In the particular embodiment of figure 3, the tuning module 160 comprises:
- a tuning mode setting module 162, for configuring the device in a tuning mode or in another mode (for instance a working mode). It can comprise for instance a button or a mechanical switch and/or a user interface for entering a login and/or password.
- a digital to audio converter 166;
- a power processing module 164;
- a delay setting module 168.

The power processing module 164 can for instance be a DSP. It receives the power value of the signal outputted by the subtractor 140 and modify, if needed, the duration of the delaying performed by the delaying module 130 via the delay setting module 168 of the tuning module 160.

In the illustrated embodiment, the delaying module comprises a main delay module 134 and a fine tuning module 136. The main delay module permits to define a large delay, for instance a default delay to be set at the factory (notably a delay smaller that the delay expected in the conception stage of the device) or to be modified in tuning mode. The fine tuning module permits to adjust the current duration of the delaying if needed. The accuracy of the fine tuning module 130 can be adapted to the sampling frequency of the converter 166. For instance, when the sampling frequency of the converter 166 is around 96 KHz, the fine tuning module can have an accuracy of 5, 10 or 20 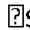 s.

In some embodiments, eventually complementary to the illustrated embodiment, the obtaining module 120 can comprise a delaying module (not illustrated), to be monitored by the delay setting module 168, in order for instance to lightly increase the time of processing of the obtaining module if it is not possible to decrease lightly the duration of the delaying of the delaying module.

In the embodiment of figure 3, the analog signal input is a sound signal. The converters can be chosen with a sampling frequency value adapted to the sensibility of the human ears, notably a value of 30 to 150 KHz, for instance 96 KHz.

As it will be apparent to the one skilled in the art, the audio processing device 100 can also comprise, or be connected to, other modules, like a display module, for instance a display screen, directly connected to a graphic card of the audio processing device 100 by a dedicated bus, a power source, an output module, comprising for instance a following amplifier 144, and a rendering module (like a loud speaker).

In the embodiment illustrated in figure 3, the tuning is performed when the device is configured in a tuning mode. In some other embodiments, the tuning can be performed when the device is in a working mode, either continuously or periodically. It such an embodiment, rather than having an obtaining module 120 configurable in a working or tuning mode, the device may comprises an obtaining module, a simulating module (distinct from the obtaining module) and two merging modules, the obtaining module and a first one of the merging modules being used for obtaining a corrective signal and merging the corrective signal with the delayed acquired signal, the simulating module and a second one of the merging modules being used for tuning the device by simulating obtaining and merging on the acquired delayed signal.

As illustrated by figure 4, at least some of the modules 40 of the audio processing device 100, like the click and/or plop extractor and/or the power processing module, can comprise following modules, link together via a data and address bus 400, which may also carry a timer signal:
- at least a micro-processor 41 (or CPU);
- at least one Input/ Output module 44;
- a ROM (or « Read Only Memory ») 45 ;
- a RAM (or « Random Access Memory ») 46.

Each of the mentioned memories may comprise at least one register, that is to say a memory zone of low capacity (a few binary data) or high capacity (with a capability of storage of a whole program or of all or part of data representative of data to be calculated or displayed).

When the audio processing device 100 is powered on, the module 40 is powered on and the microprocessor 41 loads and executes program instructions 460 contained in a register of the RAM 46, and notably the algorithms needed of performing at least one embodiment of the attenuating method described herein.

According to a variant, the module 40 can comprise several microprocessors.

## Claims

1. A method, to be performed in a signal processing device, for attenuating a peak present in a first analog signal, said method being **characterized in that** it comprises:
- delaying said first analog signal for a first given duration;
- obtaining in said first given duration a corrective analog signal, said corrective analog signal being temporally aligned with said delayed first analog signal, said obtaining comprising:
• converting said first analog signal to a first digital signal;
• generating a second digital signal from said first digital signal by isolating at least a peak;
• building said corrective analog signal from said second digital signal thanks to an audio to digital conversion;
- merging said delayed analog signal with said corrective analog signal.

2. An attenuating method according to claim 1 **characterized in that**:
- said building comprises:
• inverting the polarity of said second digital signal;
• audio to digital converting of said inverted second digital signal; and
- said merging comprises adding said delayed analog audio signal with said corrective analog signal.

3. An attenuating method according to claim 1 **characterized in that**:
- said building comprises:
• converting said second digital signal to a second analog signal;
• inverting the polarity of said second analog signal; and
- said merging comprises adding said delayed analog audio signal with said corrective analog signal.

4. An attenuating method according to claim 1 **characterized in that** said corrective signal has the same polarity than the first analog signal and said merging comprises subtracting said corrective analog signal from said delayed analog audio signal.

5. An attenuating method according at least one of claims 1 to 4 **characterized in that** said attenuating method comprises tuning said first given duration.

6. An attenuating method according to claim 5 **characterized in that** said signal processing device is configurable in a tuning mode and said tuning is performed when said signal processing device is in said tuning mode.

7. An attenuating method according to at least one of claims 5 to 6 **characterized in that** said tuning comprises :
- obtaining a third analog signal, said obtaining comprising:
• converting said first analog signal to a third digital signal;
• delaying said third digital signal for a second given duration;
• building said third analog signal from said third digital signal thanks to an audio to digital conversion;
- merging said delayed analog signal with said third analog signal;
- modifying said given duration according to the power of the merged signals.

8. A signal processing device for attenuating a peak present in a first analog signal, said signal processing device being **characterized in that** it comprises:
- a delay module, configured for delaying said first analog signal for a first given duration;
- an obtaining module, configured for obtaining a corrective analog signal in said first given duration, said corrective analog signal being temporally aligned with said delayed first analog signal, said obtaining module comprising:
• an audio to digital converter, configured for converting said first analog signal to a first digital signal;
• a generating module, configured for generating a second digital signal from said first digital signal by isolating at least a peak;
• a building module, configured for building said corrective analog signal from said second digital signal thanks to an audio to digital conversion;
- a merging module, configured for merging said delayed analog signal with said corrective analog signal.

9. A signal processing device according to claim 8 **characterized in that** said isolating module comprises a high pass filtering module.

10. A signal processing device according to claim 9 **characterized in that** said isolating module comprises a smooth filtering module.

11. A signal processing device according to at least one of claims 8 to 10 **characterized in that** said signal processing device comprises an acquiring module for acquiring said first analog signal from an analog sound record.

12. A signal processing device according to at least one of claims 8 to 11 **characterized in that** said device comprises at least a tuning module configured for adjusting said first given duration.

13. A signal processing device according to at least one of claims 8 to 12 **characterized in that** said tuning module comprises a delay setting module.

14. A signal processing device according to at least one of claims 8 to 13 **characterized in that** said tuning module comprises at least two delay setting modules.

15. A signal processing device according to at least one of claims 8 to 14 **characterized in that** said tuning module comprises a power processing unit.
